# EUROPEAN PATENT SPECIFICATION

(11) **EP 3 460 840 B1**
(45) Date of publication and mention of the grant of the patent: **20.05.2020**
(21) Application number: 18195876.0
(22) Date of filing: 21.09.2018
(51) Int. Cl.: H01L 23/40, H01L 23/473, H02M 7/00, H05K 7/20

(54) **DEVICES FOR ATTACHING AND SEALING A SEMICONDUCTOR COOLING STRUCTURE**
VORRICHTUNGEN ZUM BEFESTIGEN UND ABDICHTEN EINER HALBLEITERKÜHLSTRUKTUR
DISPOSITIFS POUR FIXER ET SCELLER UNE STRUCTURE DE REFROIDISSEMENT À SEMI-CONDUCTEURS

(30) Priority: 25.09.2017 US 201715713759
(43) Date of publication of application: 27.03.2019
(73) Proprietor: General Electric Company, Schenectady, NY 12345 (US)
(72) Inventor: DONNELLY, Thomas Robert, Salem, VA Virginia 24153 (US); WAGONER, Robert Gregory, Salem, VA Virginia 24153 (US)
(74) Representative: Zimmermann & Partner Patentanwälte mbB

(56) References cited:
- EP-A1- 3 086 454
- US-A1- 2010 232 112
- US-A1- 2013 215 573
- US-A1- 2016 118 317

## Description

The present subject matter relates generally to wind turbines and, more particularly, to methods and devices for attaching and sealing a cooling structure onto power semiconductor modules to form semiconductor packages for power converters.

Modern wind turbines are used to supply electricity into the electrical grid generally through a power converter that uses various power electronic systems. Semiconductor packages may be used to control power distribution to the various applications and devices of the power electronic system. A semiconductor package may generally include a number of semiconductor chips which function as current switches for relatively high voltage ranges. The semiconductors used in the package may have certain limitations, such as maximum breakdown voltage and current carrying capability. Due to the blocking voltage limitations of each individual semiconductor, several semiconductors may be connected in series to achieve the required voltage and to function in a higher power system. For example, insulated gate bipolar transistors (IGBTs) may have a relatively low voltage breakdown, and several IGBTs may be interconnected within a semiconductor package in parallel for high current capability and several IGBT packages could be connected in series in a stack to meet high voltage requirements, and hence allow switching in relatively high power applications. Furthermore, due to the need for high current in power electronic systems, semiconductor chips may also be arranged in sub-groups within a semiconductor package. For example, several groups of series-connected IGBTs may also be arranged in parallel in the package.

Semiconductor devices generate heat when placed in service. Many known heat removal systems for such semiconductors include a path for heat flow with a high thermal resistance, thereby resulting in a high operating junction temperature for a particular amount of power loss in the semiconductor device. For example, the cooling path for many IGBT modules includes a semiconductor die soldered onto one side of an electrically-isolating substrate, e.g., aluminum nitride, thereby forming an electrical junction thereon. Most of the heat generated by the IGBT is channeled from the junction side of the electrically-isolating substrate, through the substrate, to the opposite side. Many such known substrates include a heat transfer mechanism on the side opposite the junction. This heat transfer mechanism is typically referred to as single-side cooling structure.

Some large power semiconductors often consist of a high number of silicon chips or dies connected in series or parallel, depending on the use, and may be attached to a common board. Such large power semiconductors are often called power modules. Liquid cooling of power modules often involves having a cooling structure attached to the bottom, i.e. the base plate of the module. The cooling structure contains a closed circuit for a liquid coolant that may include inlet(s) and outlet(s) for providing fluid connections to a heat exchanger. This method is known as indirect cooling.

Direct cooling of power semiconductor modules is also practiced, and involves a chamber for the liquid coolant defined in a cavity of the cooling structure. The base plate of the power semiconductor module may be attached to the cooling structure over the cavity, effectively acting as a lid to cover the cavity and placing the coolant in the cavity in thermal contact with the base plate for heat removal therefrom. Fasteners, such as bolts are screws, are often used to secure the cooling structure and base plate. The actual flow and/or heat transfer of the liquid coolant can be made in many different ways. One way is by using a distributing element, which is inserted in the cavity, and another known way is by having an array of cooling fins protruding from the base plate into the liquid coolant. For example, US 2010/232112 A1 describes a semiconductor module including a base plate whose one surface is formed with a fin region in which a cooling fin is provided. A substrate is disposed on the other surface of the base plate and provided with a switching device. A case member has an internal space. An opening is formed in one wall of the case member so that the opening is smaller than the one surface of the base plate and larger than the fin region. US 2013/215573 A1 describes a motor controller comprising a capacitor, a laminated bus and an inverter module including an inverter circuit coupled to a baseplate, wherein the baseplate includes cooling features. A cooling channel is configured to receive a cooling fluid. The cooling features extend into the cooling channel. The laminated bus electrically couples the capacitor to the inverter circuit and thermally couples the capacitor to the cooling channel.

Various aspects and advantages of the invention will be set forth in part in the following description, or may be clear from the description, or may be learned through practice of the invention.

In one aspect, a power semiconductor package is disclosed having a base plate with a first surface and an opposing second surface. At least one power semiconductor module can be mounted to the first surface of the base plate. A flexible cooling structure having at least one cavity for containing a cooling liquid therein is disclosed. At least one flow meter is arranged with the at least one cavity. A contact rim is arranged around a perimeter of the cavity and configured to receive an adhesive. The contact rim is affixed parallel to and abutting against the second surface of the base plate thereby forming a hermetic seal at the adhesive.

In another aspect, a power converter is disclosed having at least one DC capacitor, and at least two three-phase bi-directional AC-DC converters, the AC-DC converters having at least one power semiconductor package described above.

In an example, a method for attaching and sealing a semiconductor cooling structure in a semiconductor package is disclosed having the steps of: identifying a base plate of a semiconductor package, the base plate comprising a first surface and an opposing second surface; mounting at least one power semiconductor module to the first surface of the base plate; matching a cooling structure to the base plate, the cooling structure comprising at least one cavity for containing a cooling liquid therein; preparing a contact rim arranged around a perimeter of the cavity, the contact rim configured to receive an adhesive; and, affixing the contact rim parallel to and abutting against the second surface of the base plate thereby forming a hermetic seal at the adhesive. Various features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

In the drawings:
FIG. 1 illustrates a block diagram of an electronic system which may include power semiconductor packages in accordance with an embodiment of the present invention;
FIG. 2 illustrates a prior art isometric of an open direct cooling heat sink with a gasket and power module;
FIG. 3 illustrates an exploded view of the components of an exemplary closed or integrated power semiconductor package;
FIG. 4 illustrates an assembled view of an exemplary closed or integrated power semiconductor package;
FIG. 5 illustrates a closed power semiconductor package with room for six power semiconductor modules fitted to a direct cooled cooling structure;
FIG. 6 illustrates a section cut through the closed power semiconductor package shown in FIG. 4.

Repeat use of reference characters in the present specification and drawings is intended to represent the same or analogous features or elements of the present disclosure.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims and their equivalents.

In general, the present subject matter discloses devices for attaching and/or sealing a cooling plate to a semiconductor module using adhesive in place of fasteners and O-rings. These devices are useful when implementing a direct coolant to baseplate configuration where a cooling structure is affixed to the bottom of the semiconductor module. An issue that arises is the need to seal the contact rim of the cooling structure against the semiconductor module. Current practice is to provide an O-ring around the contact rim of the cooling structure and screw it to the base of the semiconductor module. An improved method disclosed herein uses an adhesive to bond and seal the cooling structure to the semiconductor module at the contact rim to make a power semiconductor integrated package thus removing a failure mode of coolant leakage at the O-ring. Cyclic temperature operations of the semiconductor module changes the ductility of the O-ring thereby causing the O-ring to become more rigid and fragile over time thus compromising the coolant seal. Using an adhesive in place of an O-ring removes a high-risk failure area of the sealed direct water cooled semiconductor integrated package. Also, by using an adhesive, the fasteners (screws) that hold the cooling structure to the semiconductor module can be eliminated. By utilizing adhesive in place of an O-ring and fasteners, fabrication can be more readily automated. Additive manufacturing can build a complete base plate and cooling structure that includes a flow distributing element. Discrete semiconductor components can then be mounted to the base plate to construct the semiconductor module. This would eliminate the need for affixing a cooling structure to the bottom of a semiconductor module.

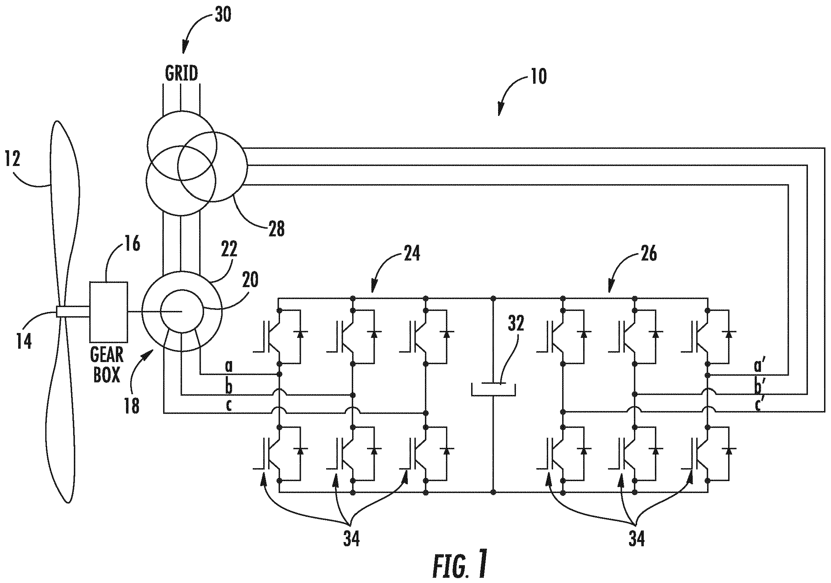

FIG. 1 illustrates a block diagram of an electronic system which may include power semiconductor packages 34 in accordance with a wind power converter system 10 embodiment of the present disclosure. The wind power converter system 10 may be suitable for capturing power from wind using turbine blades 12 and converting the captured wind power into mechanical power, and the mechanical power into electrical power. The system 10 may include a gearbox 16 connected to the turbine rotor 14 of the turbine blades 12. The gearbox 16 may adapt the relatively low speed of the turbine rotor 14 with the relatively high speed of a generator 18.

The generator 18 may convert the mechanical power into electrical power, and may be, for example, an induction generator or a synchronous generator. For example, the generator 18 illustrated in FIG. 1 may be a doubly fed induction generator (DFIG), which includes a rotor winding 20 and a stator winding 22. The stator winding 22 of the generator 18 may be connected to a transformer 28 which transfers electrical power through inductively coupled conductors to a suitable voltage level for an electrical grid 30. The grid 30 may be an interconnected network which delivers electrical power to various other electrical devices or networks. The rotor winding 20 of the generator 18 may be connected to the grid 30 by converters 24 and 26 which decouple mechanical and electrical frequencies (e.g., to enable variable-speed operation).

The system 10 may include two three-phase AC-DC converters 24 and 26 linked by a DC capacitor 32. The converter 24 connected to the rotor winding 20 of the generator 18 may be referred to as the rotor side converter 24, while the converter 26 connected to the grid 30 by the transformer 28 may be referred to as the grid side converter 26. The bidirectional converters 24 and 26 may enable vector control of the active and reactive powers delivered to the grid 30 and may also increase power quality and angular stability and decrease the harmonic content introduced into the grid 30 (e.g., via filters).

The converters 24 and 26 may be used for varying levels of power control, and may use relatively high power (voltage and current), so the transistors used in the converters 24 and 26 may be suitable for switching high voltages. As semiconductor switches may have inherent limitations for maintaining thermal stability, several semiconductor devices may be packaged together to control power for the system 10. For example, the converters 24 and 26 may include several semiconductor packages 34 such as insulated gate bipolar transistors (IGBTs). In some embodiments, the IGBTs 34, or any other transistors used in the converters 24 and 26 may be packaged in one or more semiconductor packages structured and/or manufactured according to the embodiments described herein.

It should be appreciated that Fig. 1 illustrates a non-limiting embodiment of the invention. Power bridges made from semiconductor packages disclosed herein can be used in numerous applications including solar and automotive. In these cases, the illustrated DC capacitor 32 can be any DC source such as a battery or photovoltaic array and the 3-phase AC output might feed a power grid, motor, pump, light bulb or any other electrical load.

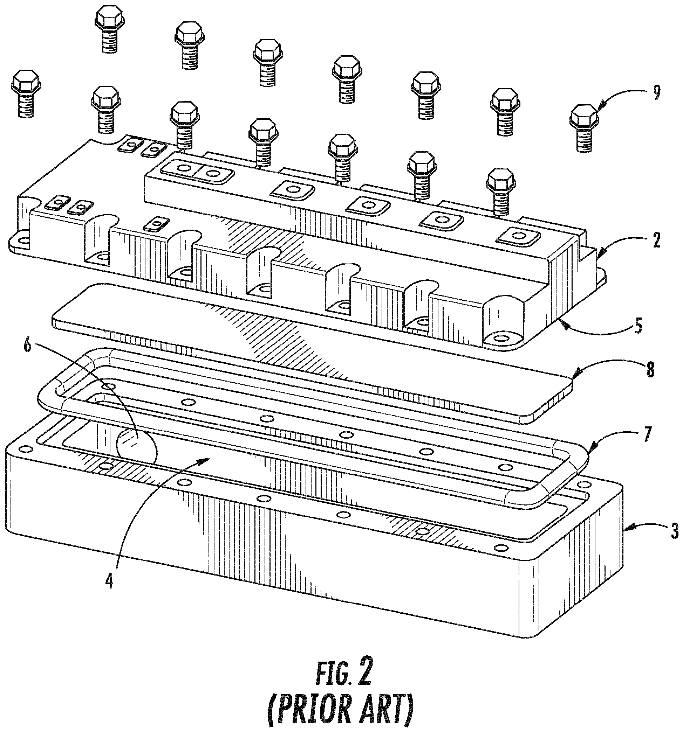

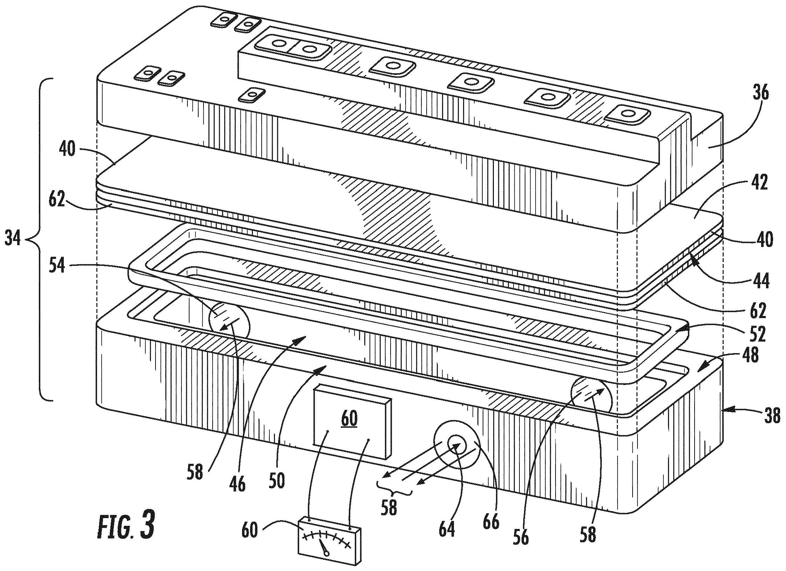

Direct liquid-cooling of power semiconductor packages 34 can further be categorized into an open structure, as seen in the prior art of FIG. 2, and a closed or integrated structure, as taught herein and shown in FIGS. 3 thru 6. FIG. 2 illustrates a prior art open structure using a direct cooling heat sink 3 with its basin 4 and an inlet and/or outlet 6. A gasket or O-ring 7 is used as a seal and is inserted between the heat sink 3 and the power module 2 containing a base plate 5. To ensure an even distribution of the liquid coolant, a flow distributing element 8 is inserted in the basin 4. The power module 2 is screwed or bolted to the heat sink 3 by bolts or screws 9. Bending stresses caused by the power module 2 mounting screws 9 combined with the force exerted by a gasket 7 and pressure pulses from the coolant on the baseplate can cause the semiconductor ceramic substrate material to crack, violating electrical insulation properties and destroying the device instantaneously.

Additionally, in the open structures of FIG. 2, it is often practical to use a power module 2 with a pre-bend base plate 5. When attaching a pre-bend base plate 5 to the heat sink 3 with a flat upper edge of the basin 4, forces from the bolts or screws 9, combined with a gasket 7 acting as a fulcrum, will try to flatten out the pre-bent base plate 5 which will cause the semiconductor ceramic chip substrate to crack and result in isolation failure. Also, installing the fixing screws 9 is a time intensive process, usually conducted by hand, requiring skilled labor for proper torqueing. If fins or other heat transfer enhancements are used to extend the surface area of the base plate 5, a clearance is provided between the fin tips and the heat sink basin 4 to allow for travel distance during O-ring compression and sealing.

An effective solution to these problems is a closed or integrated power semiconductor package 34, as taught herein and illustrated in FIGS. 3 - 6. FIG. 3 illustrates an exploded view of an integrated power semiconductor package 34 that can have the base plate 40 integrated with the cooling structure 38 by applying an adhesive 52 as a sealant, instead of a compressive O-ring of an open structure, thereby avoiding the need for screws and clearance between the base plate 40 and the cooling structure cavity 46. The base plate 40 can have a first surface 42 and an opposing second surface 44 with at least one power semiconductor module 36 mounted to the first surface 42. A cooling structure 38 can have at least one cavity 46 for containing a cooling liquid 58 therein, and a contact rim 48 arranged around a perimeter of the cavity 46. The cavity 46 can have an inlet 54 and an outlet 56 for circulating the cooling liquid 58 inside the cavity 46. The inlet 54 and the outlet 56 can be positioned concentric with each other such that cooling liquid 58 flows into the cavity 46 through an inner port 64 and counter-flows out of the cavity in an outer annular port 66 positioned concentric with the inner port 64. The cooling structure 38 can have a flow distributing element 62 in fluid communication with the cooling liquid 58 in the cavity 46 for maintaining proper cooling liquid 58 flow distribution along the second surface 44 of the base plate 40 and to maximize heat transfer from the base plate 40. Cooling fins and other heat transfer surface extensions can extend from the base plate 40 to enhance heat transfer. A contact rim 48 can be arranged around a perimeter of the cavity 46 and configured to receive an adhesive 52. The contact rim 48 can be affixed parallel to and abutting against the second surface 44 of the base plate 40 thereby forming a hermetic seal at the adhesive 52. The hermetic seal is defined herein as meeting Military Standard 883; Test Method 1014. Using adhesive 52 as the sealing mechanism permits any appropriate material to be used for the cooling structure 38.

The cavity 46 is constructed from flexible material and the adhesive 52 sealant. A flow meter 60 is attached to the cooling structure cavity 46. A non-limiting example of a flow meter 60 is a strain gauge to measure the amount of cavity deflection caused by cooling liquid 58 flowing through the cooling structure 38, and then correlate the amount of cavity deflection to a specific cooling liquid 58 flow rate. The strain gauge flow meter 60 can also be used to detect coolant flow distribution problems in the power semiconductor package 34 integrated structure. It should be appreciated that any type of flow meter 60 can be applied in the semiconductor package 34 to measure the cooling liquid 58 flow rate.

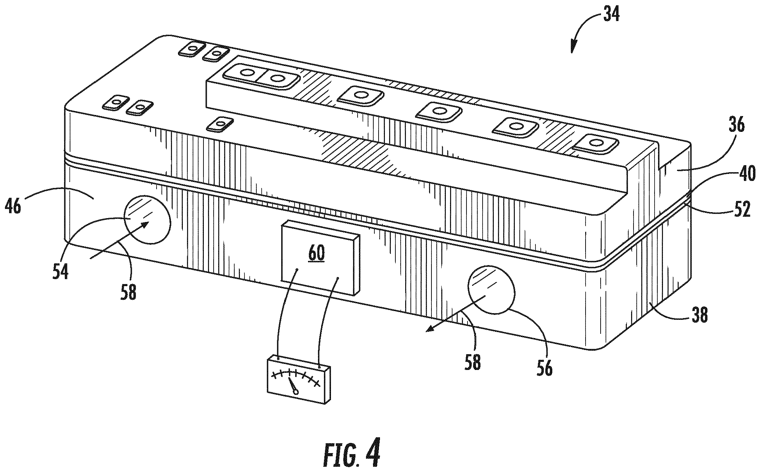

FIG. 4 illustrates an assembled view of an exemplary closed or integrated power semiconductor package 34 showing the base plate 40 integrated with the cooling structure 38 by applying an adhesive 52 as a sealant. A cooling structure 38 can have at least one cavity 46 for containing a cooling liquid 58 therein, and a contact rim 48 arranged around a perimeter of the cavity 46. The cavity 46 can have an inlet 54 and an outlet 56 for circulating the cooling liquid 58 inside the cavity 46. The cooling structure 38 can have a flow distributing element (not shown) in contact with the cooling liquid 58 in the cavity 46 for maintaining proper cooling liquid 58 flow distribution along the base plate 40.

Adhesive 52 bonding of the baseplate 40 substrate with the cooling structure 38 substrate can be difficult because each substrate can have different coefficients of thermal expansion (CTE). Additionally, stresses caused by temperature extremes in service and thermal cycling of the semiconductor package 34 sometimes makes a difficult situation more complicated. Adhesives 52 can be selected with CTE's as close as possible to the materials being bonded. Or, a more flexible and toughened adhesive can be applied to compensate for the CTE mismatch between the baseplate 40 and the cooling structure 38. For example, the baseplate 40 can be a metal and the cooling structure 38 can be a plastic. Consideration of service conditions, shrink rates, and substrate material CTE mismatches is necessary for proper adhesive 52 selection.

When low shrinkage, low thermal expansion and dimensional stability is required, the adhesive 52 can be, for example, Master Bond EP30LTE, having linear CTE in the range of about 14.4^{∗}10⁻⁶ K⁻¹ to about 180.0^{∗}10⁻⁶ K⁻¹ (about 8.0 to about 10.0 microinches/inch-°F). For other applications, Scotch-Weld Adhesive 2214 as manufactured by 3M is a suitable adhesive 52 for bonding the power semiconductor packages 34. The operating temperature range of the Scotch-Weld adhesive 52 can be about -51.1°C to about +121.2°C (about -60°F to about +250°F), and the linear CTE for the Scotch-Weld adhesive 52 can be about 43.2 to about 135.0^{∗}10⁻⁶ K⁻¹ (about 24.0 to about 75 microinches/inch-°F). The adhesive 52 can be applied as a continuous bead on the flat surface 50 of the contact rim 48 thereby making the adhesive 52 a contiguous seal to prevent coolant leakage through many operating cycles. The adhesive 52 seal is located outside of the heat conductive path between the base plate 40 and the cooling liquid 58. Thus, the cooling performance of the semiconductor package 34 is not sensitive to the thermal conductivity properties of the adhesive 52.

The cooling structure 38 is constructed from flexible materials such as molded flexible plastic, fiber reinforced plastic, composites, rubber compounds and combinations thereof. Using a flexible cooling structure 38, a flow meter 60, such as a strain gauge, can be arranged with the cavity 46 to detect cooling liquid 58 flow rate in the cavity 46. Additionally, the flow distributing element 62 can have micro-channels for proper distribution of the cooling liquid 58.

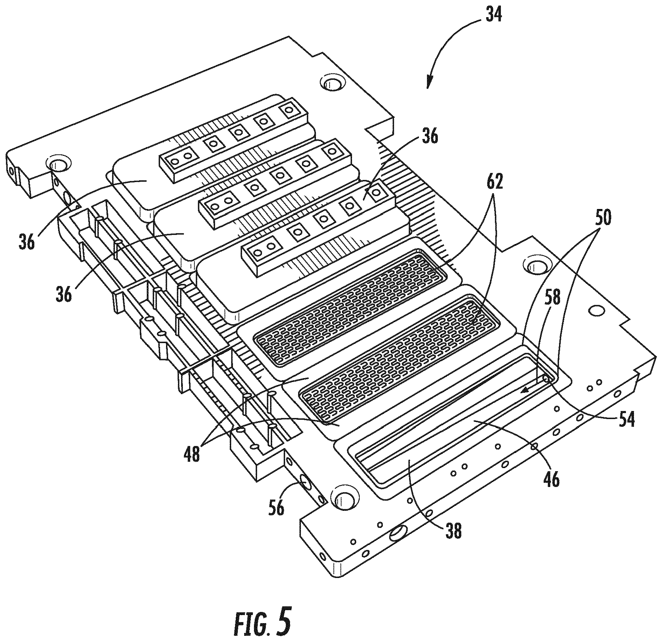

As illustrated in FIG. 5, an embodiment of the semiconductor package 34 with a six cooling structures 38 and six cavities 46 for receiving six semiconductor modules 36. Such a cooling structure may have common inlet 54 and outlet 56 extending between each cavity 46 for the cooling liquid 58. The semiconductor modules 36 may contain semiconductor devices such as insulated gate bipolar transistors (IGBTs), metal oxide semiconductor field effect transistors (MOSFETs), bipolar junction transistors (BJTs), integrated gate-commutated thyristors (IGCTs), gate turn-off (GTO) thyristors, Silicon Controlled Rectifiers (SCRs), diodes and combinations thereof. The devices can be constructed from materials such as Silicon (Si), Silicon Carbide (SiC), Gallium Nitride (GaN), Gallium Arsenide (GaAs), and combinations thereof.

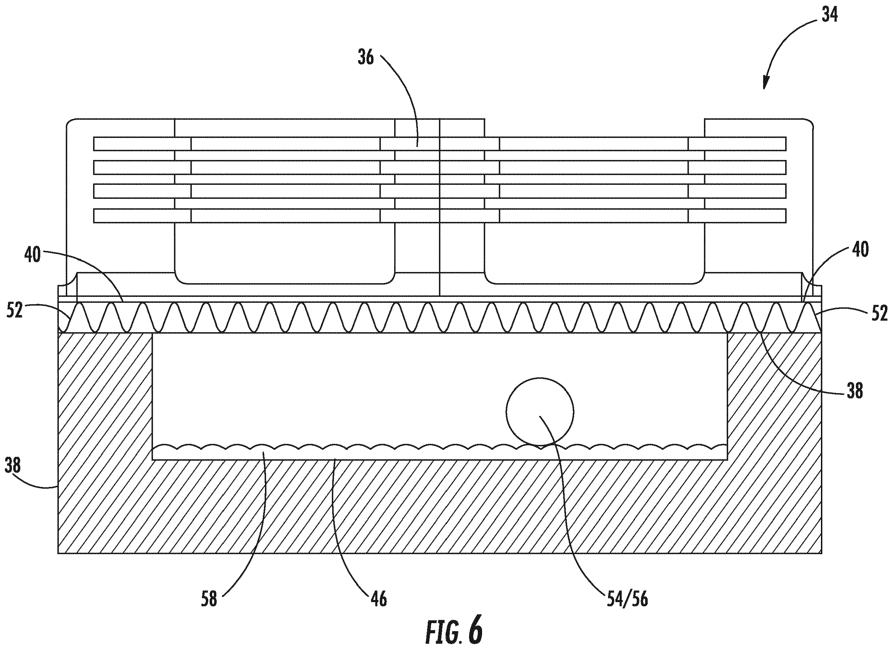

FIG. 6 illustrates a section cut through the closed power semiconductor package 34 as shown in FIG. 4 having the base plate 40 integrated with the cooling structure 38 by applying an adhesive 52 as a sealant. A cooling structure 38 can have at least one cavity 46 for containing a cooling liquid 58 therein. The cavity 46 can have an inlet 54 and an outlet 56 for circulating the cooling liquid 58 inside the cavity 46.

A method for attaching and sealing a semiconductor cooling structure 38 in a semiconductor package 34 can have the steps of: identifying a base plate 40 of a semiconductor package 34, the base plate 40 comprising a first surface 42 and an opposing second surface 44; mounting at least one power semiconductor module 36 to the first surface 42 of the base plate 40; matching a cooling structure 38 to the base plate 40, the cooling structure 38 comprising at least one cavity 46 for containing a cooling liquid 58 therein; preparing a contact rim 48 arranged around a perimeter of the cavity 46, the contact rim 48 configured to receive an adhesive 52; and affixing the contact rim 48 parallel to and abutting against the second surface 44 of the base plate 40 thereby forming a hermetic seal at the adhesive 52. Additional method steps can include: mounting at least one flow meter 60 to the at least one cavity 46; measuring the amount of cavity 46 deflection caused by cooling liquid 58 flowing through the cooling structure 38, and correlating the amount of cavity deflection to a specific cooling liquid 58 flow rate.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A power semiconductor package (34), comprising:
a base plate (40) comprising a first surface (42) and an opposing second surface (44);
at least one power semiconductor module (36) mounted to the first surface (42) of the base plate (40);
a flexible cooling structure (38) comprising at least one cavity (46) for containing a cooling liquid (58) therein, and at least one flow meter (60) arranged with the at least one cavity (46), wherein a contact rim (48) is arranged around a perimeter of the at least one cavity (46) and configured to receive an adhesive (52), the contact rim (48) affixed parallel to and abutting against the second surface (44) of the base plate (40) thereby forming a hermetic seal at the adhesive (52).

2. The power semiconductor package (34) of claim 1, wherein the at least one cavity (46) comprises an inlet (54) and an outlet (56) for circulating the cooling liquid (58).

3. The power semiconductor package of any preceding claim, wherein the coefficient of thermal expansion of the adhesive (52) is in the range of about 14.4^{∗}10⁻⁶ K⁻¹ (8.0 micro-inches/inch-°F) to about 135.0^{∗}10⁻⁶ K⁻¹ (75.0 micro-inches/inch-°F).

4. The power semiconductor package (34) of any preceding claim, wherein the cooling structure (38) comprises at least two cavities.

5. The power semiconductor package (34) of any preceding claim, wherein the cooling structure (38) further comprises a flow distributing element (62) in fluid communication with the cooling liquid (58).

6. The power semiconductor package (34) of any preceding claim, wherein the semiconductor package (34) is a closed or integrated structure.

7. A power converter (10), comprising;
at least one DC capacitor (32), and,
at least two three-phase bi-directional AC-DC converters (24, 26), the AC-DC converters (24, 26) comprising at least one power semiconductor package (34), the at least one power semiconductor package (34) comprising:
a base plate (40) comprising a first surface (42) and an opposing second surface (44);
at least one power semiconductor module (36) mounted to the first surface (42) of the base plate (40); and,
a flexible cooling structure (38) comprising at least one cavity (46) for containing a cooling liquid (58) therein, and at least one flow meter (60) arranged with the at least one cavity (46), wherein a contact rim (48) is arranged around a perimeter of the at least one cavity (46) and configured to receive an adhesive (52), the contact rim (48) affixed parallel to and abutting against the second surface (44) of the base plate (40) thereby forming a hermetic seal at the adhesive (52);
wherein the semiconductor package (34) is a closed or integrated structure.

8. The power converter (10) of claim 7, wherein the coefficient of thermal expansion of the adhesive (52) is in the range of about 14.4^{∗}10⁻⁶ K⁻¹ (8.0 microinches/inch-°F) to about 135.0^{∗}0⁻⁶ K⁻¹ (75.0 micro-inches/inch-°F).

9. The power converter (10) of claim 7 or 8, wherein the cooling structure (38) comprises at least two cavities.

10. The power converter (10) of claim 7, 8 or 9, wherein the cooling structure (38) further comprises a flow distributing element (62) in fluid communication with the cooling liquid (58).

11. The power converter (10) of any of the claims 7 to 10, wherein the at least one cavity (46) comprises an inlet (54) and an outlet (56) for circulating the cooling liquid (58).

12. The power converter (10) of any of the claims 7 to 11, wherein the cooling structure (38) is constructed of at least one of metal, molded plastic, fiber reinforced plastic, composites, and combinations thereof.

## Patentansprüche

1. Leistungshalbleitergehäuse (34), umfassend:
eine Grundplatte (40), die eine erste Oberfläche (42) und eine gegenüberliegende zweite Oberfläche (44) umfasst;
mindestens ein Leistungshalbleitermodul (36), das an der ersten Oberfläche (42) der Grundplatte (40) angebracht ist;
eine flexible Kühlstruktur (38), die mindestens einen Hohlraum (46) zum Aufnehmen einer Kühlflüssigkeit (58) darin umfasst, und mindestens einen Durchflussmesser (60), der mit dem mindestens einen Hohlraum (46) angeordnet ist, wobei ein Kontaktrand (48) um einen Umfang des mindestens einen Hohlraums (46) angeordnet ist und konfiguriert ist, um einen Klebstoff (52) aufzunehmen, wobei der Kontaktrand (48) parallel zu und angrenzend an die zweite Oberfläche (44) der Grundplatte (40) befestigt ist, wodurch eine hermetische Abdichtung an dem Klebstoff (52) ausgebildet wird.

2. Leistungshalbleitergehäuse (34) nach Anspruch 1, wobei der mindestens eine Hohlraum (46) einen Einlass (54) und einen Auslass (56) zum Zirkulieren der Kühlflüssigkeit (58) umfasst.

3. Leistungshalbleitergehäuse nach einem der vorstehenden Ansprüche, wobei der Koeffizient der thermischen Ausdehnung des Klebstoffs (52) in dem Bereich von etwa 14,4*10⁻⁶ K⁻¹ (8,0 Mikrozoll/Zoll-°F) bis etwa 135,0*10⁻⁶ K⁻¹ (75,0 Mikrozoll/Zoll-°F) liegt.

4. Leistungshalbleitergehäuse (34) nach einem der vorstehenden Ansprüche, wobei die Kühlstruktur (38) mindestens zwei Hohlräume umfasst.

5. Leistungshalbleitergehäuse (34) nach einem der vorstehenden Ansprüche, wobei die Kühlstruktur (38) ferner ein Durchflussverteilelement (62) in Fluidverbindung mit der Kühlflüssigkeit (58) umfasst.

6. Leistungshalbleitergehäuse (34) nach einem der vorstehenden Ansprüche, wobei das Halbleitergehäuse (34) eine geschlossene oder integrierte Struktur ist.

7. Leistungswandler (10), umfassend:
mindestens einen Gleichstrom-Kondensator (32), und
mindestens zwei dreiphasige bidirektionale Wechselstrom-Gleichstrom-Wandler (24, 26), wobei die Wechselstrom-Gleichstrom-Wandler (24, 26) mindestens ein Leistungshalbleitergehäuse (34) umfassen, wobei das mindestens eine Leistungshalbleitergehäuse (34) umfasst:
eine Grundplatte (40), die eine erste Oberfläche (42) und eine gegenüberliegende zweite Oberfläche (44) umfasst;
mindestens ein Leistungshalbleitermodul (36), das an der ersten Oberfläche (42) der Grundplatte (40) angebracht ist; und
eine flexible Kühlstruktur (38), die mindestens einen Hohlraum (46) zum Aufnehmen einer Kühlflüssigkeit (58) darin aufweist, und mindestens einen Durchflussmesser (60), der mit dem mindestens einen Hohlraum (46) angeordnet ist, wobei ein Kontaktrand (48) um einen Umfang des mindestens einen Hohlraums (46) angeordnet ist und konfiguriert ist, um einen Klebstoff (52) aufzunehmen, wobei der Kontaktrand (48) parallel zu und angrenzend an die zweite Oberfläche (44) von der Grundplatte (40) befestigt ist, wodurch eine hermetische Abdichtung an dem Klebstoff (52) ausgebildet wird;
wobei das Halbleitergehäuse (34) eine geschlossene oder integrierte Struktur ist.

8. Leistungswandler (10) nach Anspruch 7, wobei der Koeffizient der thermischen Ausdehnung des Klebstoffs (52) in dem Bereich von etwa 14,4*10⁻⁶ K⁻¹ (8,0 Mikrozoll/Zoll-°F) bis etwa 135,0*10⁻⁶ K⁻¹ (75,0 Mikrozoll/Zoll-°F) liegt.

9. Leistungswandler (10) nach Anspruch 7 oder 8, wobei die Kühlstruktur (38) mindestens zwei Hohlräume umfasst.

10. Leistungswandler (10) nach Anspruch 7, 8 oder 9, wobei die Kühlstruktur (38) ferner ein Durchflussverteilelement (62) in Fluidverbindung mit der Kühlflüssigkeit (58) umfasst.

11. Leistungshalbleitergehäuse (10) nach einem der Ansprüche 7 bis 10, wobei der mindestens eine Hohlraum (46) einen Einlass (54) und einen Auslass (56) zum Zirkulieren der Kühlflüssigkeit (58) umfasst.

12. Leistungswandler (10) nach einem der Ansprüche 7 bis 11, wobei die Kühlstruktur (38) aus mindestens einem von Metall, gegossenem Kunststoff, faserverstärktem Kunststoff, Verbundwerkstoffen und Kombinationen davon ausgebildet ist.

## Revendications

1. Boîtier de semi-conducteur de puissance (34), comprenant :
une plaque de base (40) comprenant une première surface (42) et une deuxième surface opposée (44) ;
au moins un module de semi-conducteur de puissance (36) monté sur la première surface (42) de la plaque de base (40) ;
une structure de refroidissement (38) souple comprenant au moins une cavité (46) pour contenir un liquide de refroidissement (58) en son sein, et au moins un débitmètre (60) disposé avec l'au moins une cavité (46), dans lequel un rebord (48) de contact est agencé autour d'un périmètre de l'au moins une cavité (46) et conçu pour recevoir un adhésif (52), le rebord de contact (48) attaché parallèle à et venant en butée contre la deuxième surface (44) de la plaque de base (40) en formant de ce fait un joint hermétique au niveau de l'adhésif (52).

2. Boîtier de semi-conducteur de puissance (34) selon la revendication 1, dans lequel la au moins une cavité (46) comprend une entrée (54) et une sortie (56) pour faire circuler le liquide de refroidissement (58).

3. Boîtier de semi-conducteur de puissance selon une quelconque revendication précédente, dans lequel le coefficient de dilatation thermique de l'adhésif (52) se trouve dans l'intervalle d'environ 14,4*10⁻⁶ K⁻¹ (8,0 micro-pouces/pouce-°F) à environ 135,0*10⁻⁶ K⁻¹ (75,0 micro-pouces/pouce-°F).

4. Boîtier de semi-conducteur de puissance (34) selon une quelconque revendication précédente, dans lequel la structure de refroidissement (38) comprend au moins deux cavités.

5. Boîtier de semi-conducteur de puissance (34) selon une quelconque revendication précédente, dans lequel la structure de refroidissement (38) comprend en outre un élément de distribution d'écoulement (62) en communication fluidique avec le liquide de refroidissement (58).

6. Boîtier de semi-conducteur de puissance (34) selon une quelconque revendication précédente, dans lequel le boîtier de semi-conducteur (34) est une structure fermée ou intégrée.

7. Convertisseur de puissance (10), comprenant ;
au moins un condensateur DC (32), et,
au moins deux convertisseurs triphasés AC-DC bidirectionnels (24, 26), les convertisseurs AC-DC (24, 26) comprenant au moins un boîtier de semi-conducteur de puissance (34), l'au moins un boîtier de semi-conducteur de puissance (34) comprenant :
une plaque de base (40) comprenant une première surface (42) et une deuxième surface opposée (44) ;
au moins un module de semi-conducteur de puissance (36) monté sur la première surface (42) de la plaque de base (40) ; et,
une structure de refroidissement (38) souple comprenant au moins une cavité (46) pour contenir un liquide de refroidissement (58) en son sein, et au moins un débitmètre (60) disposé avec l'au moins une cavité (46), dans lequel un rebord (48) de contact est agencé autour d'un périmètre de l'au moins une cavité (46) et conçu pour recevoir un adhésif (52), le rebord de contact (48) attaché parallèle à et venant en butée contre la deuxième surface (44) de la plaque de base (40) en formant de ce fait un joint hermétique (52) au niveau de l'adhésif ;
dans lequel le boîtier de semi-conducteur (34) est une structure fermée ou intégrée.

8. Convertisseur de puissance (10) selon la revendication 7, dans lequel le coefficient de dilatation thermique de l'adhésif (52) se trouve dans la plage d'environ 14,4*10⁻⁶ K⁻¹ (8,0 micro-pouces/ pouce-°F) à environ 135,0*10⁻⁶ K⁻¹ (75,0 micro-pouces/pouce-°F).

9. Convertisseur de puissance (10) selon la revendication 7 ou 8, dans lequel la structure de refroidissement (38) comprend au moins deux cavités.

10. Convertisseur de puissance (10) selon la revendication 7, 8 ou 9, dans lequel la structure de refroidissement (38) comprend en outre un élément de distribution d'écoulement (62) en communication fluidique avec le liquide de refroidissement (58).

11. Convertisseur de puissance (10) selon l'une quelconque des revendications 7 à 10, dans lequel la au moins une cavité (46) comprend une entrée (54) et une sortie (56) pour faire circuler le liquide de refroidissement (58).

12. Convertisseur de puissance (10) selon l'une quelconque des revendications 7 à 11, dans lequel la structure de refroidissement (38) est constituée d'au moins l'un parmi du métal, du plastique moulé, du plastique renforcé par des fibres, des composites et des combinaisons de ceux-ci.
